# EUROPEAN PATENT SPECIFICATION

(11) **EP 0 631 391 B1**
(45) Date of publication and mention of the grant of the patent: **26.08.1998**
(21) Application number: 93830264.3
(22) Date of filing: 21.06.1993
(51) Int. Cl.: H03K 21/40, H03K 23/54

(54) **Decoded counter with error check and self-correction**
Zähler mit Fehlerprüfung und Fehlerkorrektur
Compteur à vérification et correction d'erreur

(43) Date of publication of application: 28.12.1994
(73) Proprietor: STMicroelectronics S.r.l., 20041 Agrate Brianza (Milano) (IT)
(72) Inventor: Fucili, Giona, I-20013 Magenta (IT)
(74) Representative: Pellegri, Alberto

(56) References cited:
- DE-B- 1 195 352
- DE-B- 2 247 540
- US-A- 3 639 740
- PATENT ABSTRACTS OF JAPAN vol. 016, no. 199 (P-1351)13 May 1992 & JP-A-4 030 398 ( MATSUSHITA ELECTRIC IND CO LTD ) 3 February 1992
- PATENT ABSTRACTS OF JAPAN vol. 016, no. 423 (E-1260)7 September 1992 & JP-A-4 145 721 ( NEC IC MICROCOMPUT SYST LTD ) 19 May 1992
- IBM TECHNICAL DISCLOSURE BULLETIN vol. 25, no. 3A, August 1982, pages 1073 - 1074 G. D. MILLER ET AL.: 'Johnson Counter with Error Correction'
- PATENT ABSTRACTS OF JAPAN vol. 6, no. 218 (E-139)(1096) 2 November 1982 & JP-A-57 121 326 ( TOKYO SHIBAURA DENKI K. K. ) 28 July 1982

## Description

The present invention relates to a decoded counter employing a shift register and which is capable of self-correcting any invalid state that may accidentally be assumed by the counter.

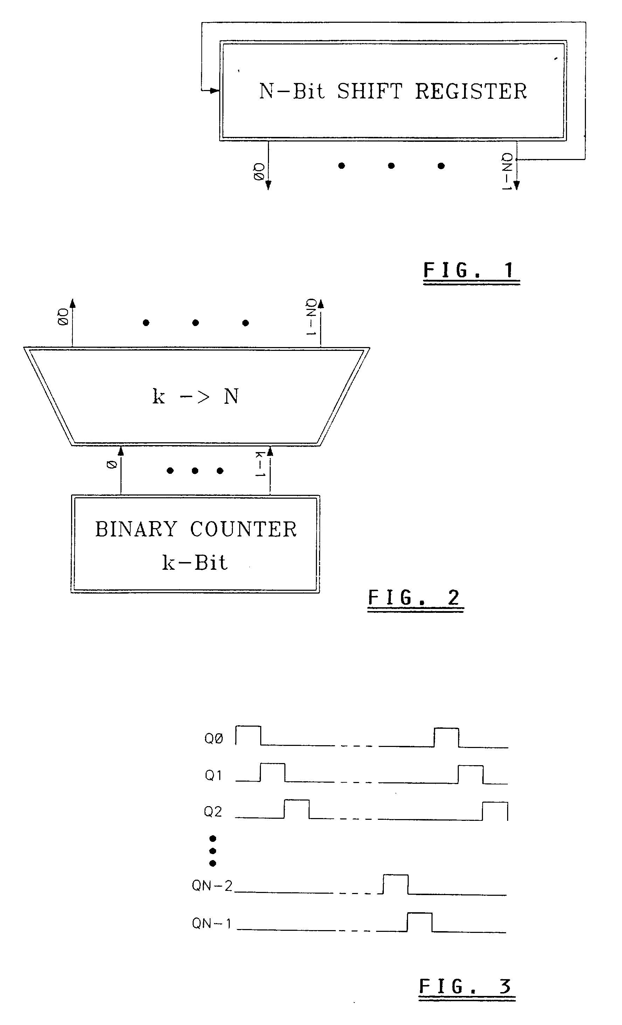

The field of the application of shift registers (SR) is extremely wide and differentiated and includes also counters. In fact, if for example the output of the last edge-triggered, D, flip-flop (FF) of a shift register (SR) is connected to the input of the first flip-flop and if to a reset input of anyone of the flip-flops is fed a logic "1", a so-called, "N-module" counter is implemented, where N is the number of flip-flops that form the shift register. A counter of this type, hereinbelow referred to also by the acronym CSR, is schematically shown in Fig. 1.

It is also well known, that the above is not a widely used solution for reallizing a counter because of several drawbacks, among which:
i) Silicon area requirements. An N-module binary counter is normally implemented with a number of FF equal to the unfractionary portion of log₂(N)+1 (if N is a multiple of 2, a number given by log₂(N) of FF would be sufficient). By contrast an equivalent counter, made with a shift register, would require an N number of FF.
ii) Power consumption. Because a CSR requires a larger number of FF, it will load more heavily the timing system (clock signal).
iii) Number of possible states. An N-module, binary counter has 2^{k} possible states (k is the minimum whole number such that 2^{k} be ≧ N). Conversely, a CSR has 2^{N} possible states. In particular, if, because of a disturbance, a unique "1" is lost, or if a second "1" is introduced, the CSR is no longer capable of "cleaning" itself and to return in a correct state.

Nothwithstanding these intrinsic drawbacks and disadvantages, a CSR may be, and is, advantageously used when extremely fast responses and symmetrical clock/output delays are required.

In fact, by assuming to have N signals that must cyclically become "high", one at the time, a solution could be that of using a binary counter followed by a K→N decoder, as depicted in Fig. 2. However, an alternative solution, could be that of using an N-module CSR, as the one depicted in Fig. 1.

The latter solution requires a larger number of FF, but in this case, the silicon area that would be required is not much different from the area that would be required by the first solution, as long as N is not too large. In fact, according to the first solution, beside K number of FF, it is necessary to implement a decoder whose architecture on the whole is not modularly structured as the circuit of the second solution is. Moreover, the K→N decoder that is required in the case of a binary counter, will introduce delays and will be hard to correctly size it so that the outputs will switch-on and off with the same switching times (in other words, symmetry of outputs is difficult to procure).

There is also another problem, that in certain applications assumes a fundamental importance, and which is represented by the necessity of ensuring that the outputs do not undergo spurious transitions, i.e. an output signal should be free of spikes following the switching of other outputs.

Unless an appropriate counting code (e.g. the well known Gray code) is used, it is not easy to ensure that a decoder be totally exempt from this problem. On the other hand, the use of reading codes, different from a normal binary representation of numbers, complicates the "rest" network of the counter.

By contrast, by using a CSR instead, although relatively improbable, one could not exclude that the CSR will assume an illegal (invalid) state, as mentioned at point iii) above.

In other words, a CSR, as the one depicted in Fig. 1, may incur in the following problems:
A) because of an accidental disturbance, more than a single FF of the shift register may store a logic "1". In this case, the synchronous machine would evolve through a sequence of states that never includes a correct one (that is a single FF storing a logic "1"), and therefore the machine would continue to count but incorrectly;
B) because of an accidental disturbance, the only logic "1" that shifts through the flip-flop chain forming the shift register may be accidentally erased. In such a case, the synchronous machine would enter a stable state and, unless it is acted upon through a suitable reset signal, the counting process would stop.

In both cases, a CSR counter may be seen as "dirtying" itself, and being unable of returning to a "clear" condition.

The document DE-B 1 195 352 discloses a decoded counter with self-correction capability, comprising a shift register, the first flip-flop of which is provided with synchronous set while all the others are provided with synchronous reset. A zero-detect circuit sets the first flip-flop, should an all-zero state be detected.

The main object of the present invention is to provide a decoded counter based on a shift register, (a CSR) that is capable of recognize the occurrence of an illegal state and to self-correct itself by returning to a correct state within a limited number of clock cycles.

This object is fully achieved by the decoded counter of the invention defined in the appended claim 1 and in the other claims dependent on claim 1. The counter comprises a shift register (SR) composed of a number N of flip-flop (FF), one of which is provided with a "set" terminal , while all the others are provided with a "reset" terminal and wherein an output of the last flip-flop of the plurality that compose the SR, drives a single synchronous set-reset line, shared by all the flip-flops. A zero-detect circuitry for reading the counter may, in general be composed of an N-input NOR gate (although, in accordance with De Morgan laws, other types of logic gates may also be used). Functionally, the zero-detect circuit is configured as a "pull-up" line, shared by all the flip-flops. Moreover, the zero-detect circuit may be either of a so-called static or dynamic type. In the latter case, the circuit employs a phase-control line for precharging the pull-up line.

The different aspects and advantages of the self-correcting decoded counter of the invention will be more easily understood through the following description of several embodiments, herein incorporated by express reference, and by referring to the attached drawings, wherein:
**Figure 1** is a schematic illustration of the structure of a counter made with a shift register (CSR), as already described above;
**Figure 2** is a schematic illustration of an equivalent binary counter provided with a decoder, as already described above;
**Figure 3** shows the signals that may be obtained either with the CSR of Fig. 1, or with the binary counter of Fig. 2;
**Figure 4** is a functional diagram of an N-module, self-correcting, decoded counter made with a shift register, according to the present invention;
**Figure 5** is the diagram of a static-type, zero-detect circuit usable in the counter of Fig. 4;
**Figure 6** is the diagram of a dynamic-type, zero-detect circuit usable in the counter of Fig. 4;
**Figure 7** shows a complete circuit diagram of a 23-module, Up-Down, self-correcting, decoded counter made according to the present invention;
**Figure 8** shows the equivalent functional diagram of a FF-shift block used for making the counter of Fig. 7;
**Figure 9** shows the result of a simulated operation of the counter of Fig. 7.

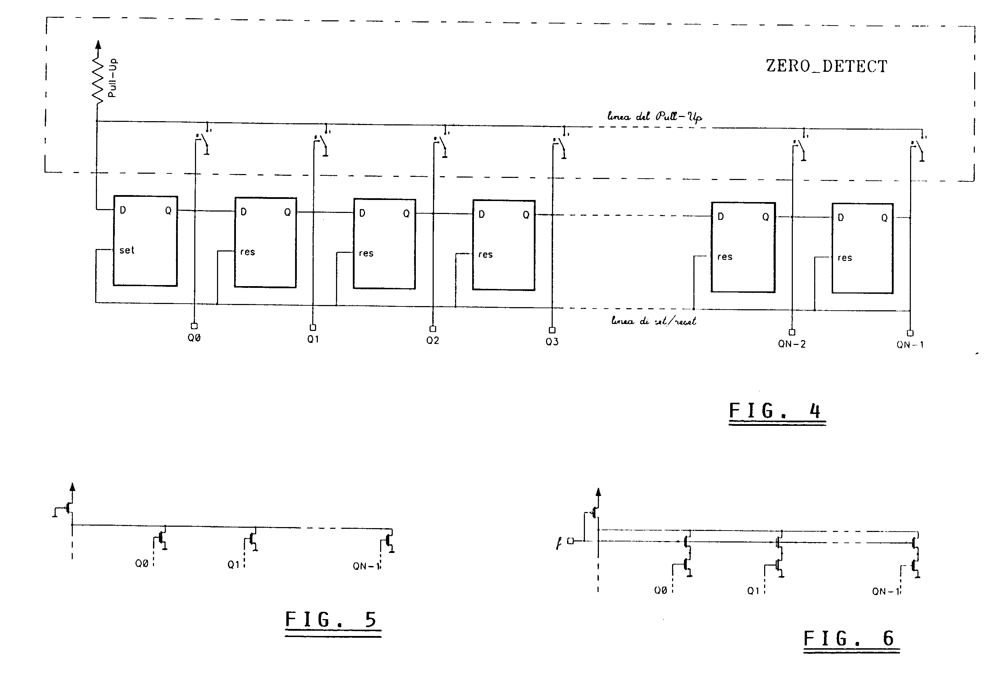

In the functional diagram of a decoded counter of the invention employing a shift register of the invention (CSR) shown in Fig. 4, all the flip-flops are of edge-triggered, D-type, with a synchronous reset, with the exception of one, for example the first of the chain, which is provided instead with a synchronous set.

All the FF may be provided also with an asynchronous reset (clear) means, with the exception of one, for example the first of the chain, which may be provided also with an asynchronous set (load). The output of a flip-flop is assumed to go high when the signal applied to a set input is high.

In practice, no asynchronous set-reset (clear/load) circuitry is needed unless the counter should start from a predefined state (as will be described later). For simplicity's sake of the illustrations, in Figures 1, 2 and 4 the clock line is not shown. It should be understood that the clock signal is the same for all the flip-flops.

It may be assumed that at the switching-on instant or at any other given instant, a circuit (not shown in the figures) will introduce a single logic "1" in the chain of FF. Such a circuitry could be functionally represented by a generator of a "clear" signal, acting through an asynchronous set-reset line simultaneously on all the FF, thus resetting all of them, with the exception of the single flip-flop, mentioned above, which, viceversa, would be set. Alternatively, such a circuitry could be functionally represented by a circuit that would generate a signal forcing the synchronous set-reset line at a high logic value, so that, in the first FF of the chain, a "1" will be loaded, while a "0" will be loaded in all the other FF of the chain.

It should be remarked again that, as will be seen later, such an initialization is not intrinsically necessary for the operation of the CSR of the invention.

The operating principle of the CSR of the invention may be summarized as follows.

In absence of disturbances, there is a single "1" that circulates through the counter structure. When it arrives at the output of the last FF of the chain, which, instead of being connected to the D input of the first FF of the chain as it would be in a CSR of a conventional type, is connected instead to a common set-reset line, imposes the reset of all the FF with the exception of the first FF of the chain, which viceversa is forced (through its synchronous set terminal) to assume the value "1". Obviously, this takes place only at the subsequent useful front of the clock signal, because the set-reset are synchronous. Moreover, the D input of the first FF (the flip-flop provided with set) as will be shown later, is generally at a logic "zero". Therefore, all the system evolves as in a normal shift register (SR) with the output of the last FF of the chain fed back to the input of the first FF (functionally in an equivalent manner as the one schematically shown in Fig. 1).

### Solution of the above-identified problem A.

Should more than a flip-flop contain a "1", when the "first" of these "1" reaches the last FF of the chain, it will automatically trigger the synchronous set-reset procedure mentioned above, therefore all the "1" will be cancelled with the exception of one, the one eventually present in the first FF, which on the contrary will be forced through the set input of the first FF.

### Solution to the above-identified problem B.

Should none of the FF contain a "1", all the switches driven by the respective FF, will be open, therefore the pull-up line assumes a high logic level through its pull-up device. In this way, at a successive useful front of the signal, the first FF of the chain will load a "1" through its D input and therefore a correct state of operation of the CSR will be re-established.

It should be observed that the CSR counter of the present invention does require any circuitry for initializing the counter (obviously if the starting condition is of no interest) because, in any event, after N-2 clock cycles at most, the counter assumes a correct operating state (i.e. at the Nth useful front of the clock signal, the CSR will positively be in a correct state).

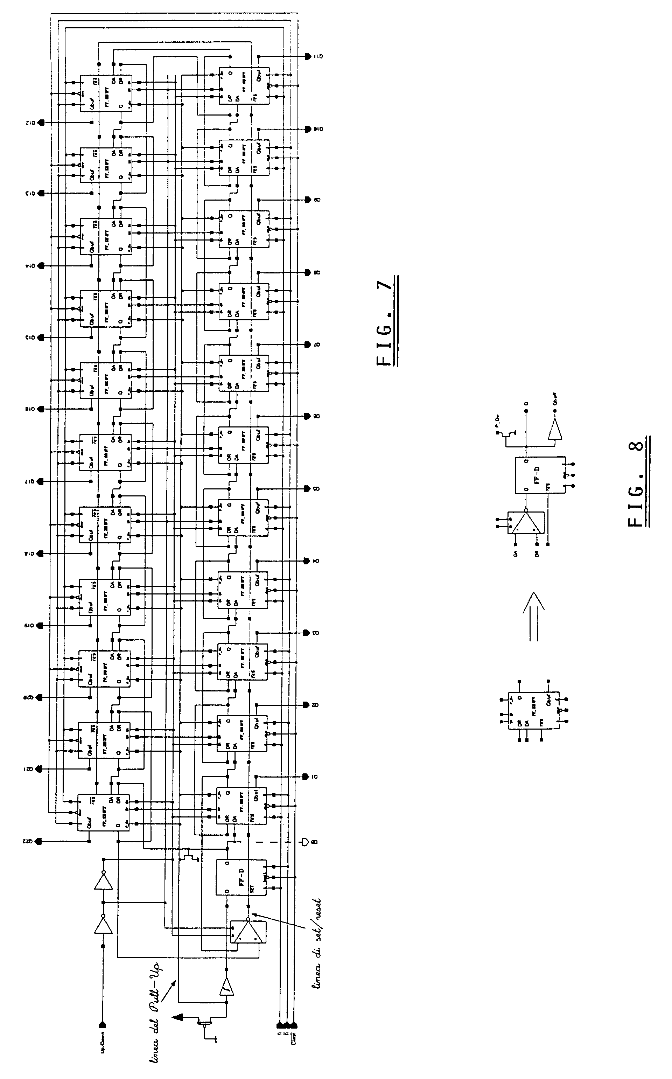

The zero-detect circuit schematically shown in Fig. 4 may be implemented in different ways. Two examples of alternative ways of realizing the zero-detect circuit are schematically shown in Figures 5 and 6. In Fig. 5, the functional diagram of a so-called static-type zero-detect circuit is shown. The operation of the circuit is evident and does not require any explanation.

The zero-detect circuit shown in Fig. 6 is of a so-called dynamic-type and employs a phase-control line (f), which allows a precharge of the pull-up line. This type of dynamic, zero-detect circuit may be used conveniently when the FF that are employed for making the counter are of the Master-Slave type. During an interval of the clock period, the Master latch is in a storing state (i.e. is not in a "read" state), therefore nothing will happen if its input changes state. During this interval of the cycle, the pull-up device (for example the p-MOS, driven by the phase signal f) precharges the pull-up line, which is momentarily decoupled from the switches functionally driven by the respective outputs Qᵢ of the FF that compose the counter, by a a second plurality of switches (in the example shown n-MOS transistors) that are controlled by the phase signal f. In the depicted example, this happens for f=0.

When the Master latch passes to a reading phase (f=1), if one of the outputs Qᵢ of one of the FF that compose the counter is at "1", the respective transistor (switch) is ON (closed) and, through the relative n-MOS that in this phase is conducting, the pull-up line is discharged. In this way a logic "0" is fed to the input D of the first FF of the chain.

When a dynamic, zero-detect circuit as the one shown in Fig. 6 is used, particular care must be exercised when designing the circuit in order to avoid charge redistribution phenomena.

Of course, from the point of view of circuit design, the solution represented by a static-type, zero-detect circuit is no doubts simpler, although slower in operation. In particular, the pull-up device (a p-MOS in the example shown) is preferably a transistor having a relatively long channel.

On the other hand, if the system is not required to recognize the absence of a "1" within a single clock cycle, the use of a static-type, zero-detect circuit will not significantly limit the clock frequency.

A 23 module, Up-Down, self-correcting, decoded counter of the invention is depicted in Fig. 7. The counter is capable of inverting the counting through a command that may be applied through a dedicated Up-Down pin. Moreover, the counter is provided with an initialization pin ($clear), which, when it goes low, resets in an asynchronous mode all the FF with the exception of the first which, on the contrary, is forced (Load 1) to store a "1". All the FF are static so as the zero-detect network. The signal, relatively slow, that is present on the pull-up line, is regenerated by the use of a Schmit trigger. The synchronous set-reset signal is generated by an appropriate buffer (contained within the multiplexer structure shown in the figure). Two clock phases (FI and $FI) are directly applied to the FF. The clock signal is generated by an appropriate driver (not depicted in the figure) that may be specifically designed for ensuring symmetry of the output transitions. The operation of the CSR shown in Fig. 7, is similar to the one described for the CSR of Fig. 4, with the difference that the iₜₕ FF receives the data on its D input from the (iₜₕ-1) FF, or from the (iₜₕ+1) FF, depending upon the value present on the Up-Down select pin. As a consequence, the set-reset line is driven by the 23th FF, that is by the second FF of the chain.

The equivalent block diagram of each FF-shift block used in the counter of Fig. 7 is shown in Fig. 8.

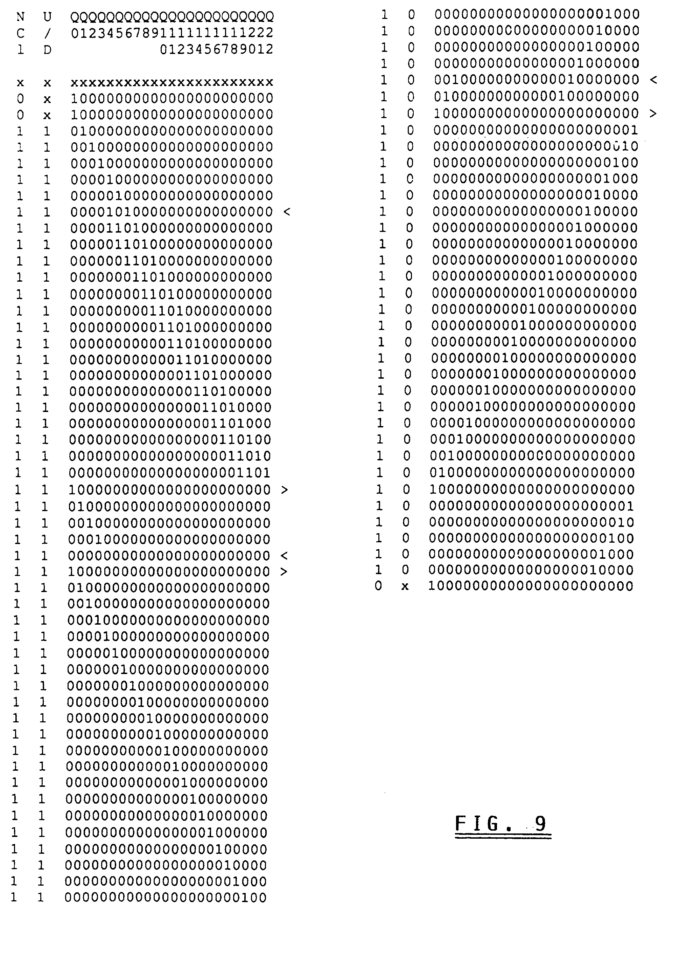

Fig. 9 is a table representing the result of a simulated operation of the 23 module, up-down, CSR counter of Fig. 7.

It should be underlined the fact that a comparable CSR counter of the prior art (Fig. la), without any self-correcting capability, would have occupied a silicon area practically identical to the area occupied by the CSR counter of the invention. In practice, between a CSR without any state control and a self-correcting CSR of the present invention, there is a difference of only three "minimum-size" MOS transistors for each FF. In general, the difference in the number of transistors will depend on the architecture of the FF used.

## Claims

1. A decoded counter with self-correction capability, comprising a shift register composed of an number N of flip-flops, the first one of which is provided with synchronous set while all the others are provided with synchronous reset and a zero-detect circuit setting the first flip-flop of the register to logic state "1" when all the flip-flops are in a logic state "0", characterized in that
the output (Q_{N-1}) of the last flip-flop of the shift register drives a single set-reset line common to all the flip-flops; and
the zero-detect circuit has a pull-up line shared by all the flip-flops and functionally connected to a D-input of the first flip-flop of the register.

2. A decoded counter as defined in claim 1, wherein said zero-detect circuit is an N-input NOR gate.

3. A decoded counter as defined in claim 2, wherein said zero-detect circuit is of a static-type, to each flip-flop being associated a switch driven by the signal present at an output of the respective flip-flop and functionally connected between said pull-up line and a ground node;
said pull-up line being connected to a supply node through a pull-up device.

4. A decoded counter according to claim 2, wherein said zero-detect circuit is of a dynamic-type and comprises
a phase-control line for precharging said pull-up line;
said pull-up line being decoupled from first switches driven by said flip-flops by second switches, functionally connected in series to said first switches and controlled through said phase-control line in common with a pull-up device.

## Patentansprüche

1. Decodierter Zähler mit Selbstkorrekturvermögen, mit einem Schieberegister, das aus einer Anzahl N von Flipflops gebildet ist, wovon das erste mit einem synchronen Setzeingang versehen ist, während sämtliche anderen mit einem synchronen Rücksetzeingang versehen sind, und einer Null-Erfassungsschaltung, die das erste Flipflop des Registers auf den logischen Zustand "1" setzt, wenn sämtliche Flipflops im logischen Zustand "0" sind, dadurch gekennzeichnet, daß
der Ausgang (Q_{N-1}) des letzten Flipflops des Schieberegisters eine sämtlichen Flipflops gemeinsame einzige Setz-Rücksetz-Leitung ansteuert; und
die Null-Erfassungsschaltung eine Pullup-Leitung besitzt, die von sämtlichen Flipflops gemeinsam genutzt wird und funktional mit einem D-Eingang des ersten Flipflops des Registers verbunden ist.

2. Decodierter Zähler nach Anspruch 1, bei dem die Null-Erfassungsschaltung ein NOR-Gatter mit N Eingängen ist.

3. Decodierter Zähler nach Anspruch 2, bei dem die Null-Erfassungsschaltung vom statischen Typ ist, wobei jedem Flipflop ein Schalter zugeordnet ist, der durch das an einem Ausgang des entsprechenden Flipflops anliegende Signal angesteuert wird und funktional zwischen die Pullup-Leitung und einen Masseknoten geschaltet ist;
wobei die Pullup-Leitung über eine Pullup-Vorrichtung mit einem Speiseknoten verbunden ist.

4. Decodierter Zähler nach Anspruch 2, bei dem die Null-Erfassungsschaltung vom dynamischen Typ ist und
eine Phasensteuerleitung zum Vorladen der Pullup-Leitung enthält;
wobei die Pullup-Leitung von den durch die Flipflops angesteuerten ersten Schaltern durch zweite Schalter getrennt wird, die mit den ersten Schaltern funktional in Serie geschaltet sind und durch die Phasensteuerleitung in Verbindung mit einer Pullup-Vorrichtung gesteuert werden.

## Revendications

1. Compteur décodé à autocorrection comprenant un registre à décalage composé d'un nombre N de bascules dont la première est munie d'une mise à un synchrone tandis que toutes les autres sont munies d'une remise à zéro synchrone et un circuit de détection de zéro mettant à un la première bascule du registre à l'état logique "1" tandis que toutes les autres bascules sont dans l'état logique "0", caractérisé en ce que :
la sortie (Q_{N-1}) de la dernière bascule du registre à décalage pilote une ligne unique de mise à un et de remise à zéro commune à toutes les bascules ; et
le circuit de détection de zéro comporte une ligne de mise à niveau haut partagée par toutes les bascules et fonctionnellement connectée à une entrée (D) de la première bascule du registre.

2. Compteur décodé selon la revendication 1, dans lequel le circuit de détection de zéro est une porte NON/OU à N entrées.

3. Compteur décodé selon la revendication 2, dans lequel le circuit de détection de zéro est du type statique, chaque bascule étant associée à un commutateur piloté par le signal présent sur une sortie de la bascule respective et fonctionnellement connecté entre la ligne de mise à niveau haut et un noeud de masse ; la ligne de mise à niveau haut étant connectée à un noeud d'alimentation par l'intermédiaire d'un dispositif de mise à niveau haut.

4. Compteur décodé selon la revendication 2, dans lequel le circuit de détection de zéro est de type dynamique et comprend :
une ligne de commande de phase pour précharger la ligne de mise à niveau haut ;
la ligne de mise à niveau haut étant découplée des premiers commutateurs pilotés par les bascules par des seconds commutateurs, fonctionnellement connectés en série aux premiers commutateurs et connectés par l'intermédiaire de la ligne de commande de phase en commun avec un dispositif de mise à niveau haut.
